(19) Europäisches Patentamt
European Patent Office
Office européen des brevets

(11) Veröffentlichungsnummer: **0 113 314**
**B1**

(12) # EUROPÄISCHE PATENTSCHRIFT

(45) Veröffentlichungstag der Patentschrift: **18.05.88**

(51) Int. Cl.⁴: **G 03 F 7/10**, C 08 F 299/04

(21) Anmeldenummer: **83810502.1**

(22) Anmeldetag: **31.10.83**

(54) **In Gegenwart von Sensibilisatoren unter Lichteinwirkung vernetzbare Stoffgemische.**

(30) Priorität: **04.11.82 CH 6417/82**

(43) Veröffentlichungstag der Anmeldung: **11.07.84 Patentblatt 84/28**

(45) Bekanntmachung des Hinweises auf die Patenterteilung: **18.05.88 Patentblatt 88/20**

(84) Benannte Vertragsstaaten: **BE CH DE FR GB LI NL**

(56) Entgegenhaltungen:
**EP-A-0 001 597**
**EP-A-0 002 182**

(73) Patentinhaber: **CIBA-GEIGY AG, Klybeckstrasse 141, CH-4002 Basel (CH)**

(72) Erfinder: **Berger, Joseph, Dr., Sperrstrasse 40/18, CH-4057 Basel (CH)**
Erfinder: **Lohse, Friedrich, Prof. Dr., Buchenstrasse 23, CH-4104 Oberwil (CH)**

**EP 0 113 314 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1988

**Beschreibung**

Die vorliegende Erfindung betrifft neue in Gegenwart von Sensibilisatoren unter Lichteinwirkung vernetzbare Stoffgemische, die daraus erhältlichen vernetzten Produkte, sowie neue Zwischenprodukte.

Aus der deutschen Offenlegungsschrift 26 26 769 und der EP-A 0 003 552 sind lichtvernetzbare Polymere mit seitenständigen Imidylgruppen, besonders Dimethylmaleinimidyl- und bestimmten tricyclischen Imidylgruppen bekannt. Deren Lichtempfindlichkeit lässt aber zum Teil noch zu wünschen übrig. Die EP-A 0 001 597 und EP-A 0 002 182 beschreiben zwar Bisimide, welche jedoch zwingend Azidgruppen enthalten.

Gegenstand der Erfindung sind neuein Gegenwart von Sensibilisatoren unter Lichteinwirkung vernetzbare Stoffgemische, enthaltend

A) ein aliphatisch ungesättigtes Polykondensationsprodukt, das gegebenenfalls Strukturelemente der Formel I

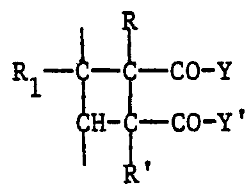

(I)

aufweist, und

B ein Bisimid der Formel II

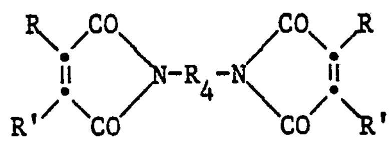

(II),

worin R und R' unabhängig voneinander $C_{1-4}$-Alkyl oder zusammen gegebenenfalls durch eine Methylgruppe substituiertes Tetramethylen oder eine Gruppierung der Formel III

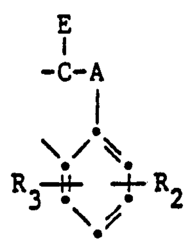

(III) ,

$R_1$ Wasserstoff oder Methyl,

$R_2$ und $R_3$ unabhängig voneinander Wasserstoff, Halogen, $C_{1-4}$-Alkyl oder Methoxy,

A $-CH_2-$, $-CH_2CH_2-$ oder $-OCH_2-$ mit an den aromatischen Ring gebundenem Sauerstoff und E Wasserstoff oder A -O- und E $-CH_3$,

$R_4$ $-C_mH_{2m}-$ mit m = 1 bis 20, $-(CH_2)_xQ(CH_2)_{x'}-$, $-(CH_2)_2NH(CH_2)_2CH_2)_2-$, $-CH_2-Z-CH_2-$, Phenylen, das durch ein oder zwei Chloratome oder eine oder zwei Methylgruppen substituiert sein kann, Naphthylen, eine Gruppe

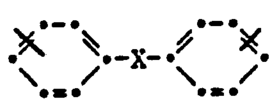

oder

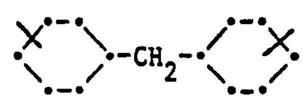

,

Q -S-, -O- oder insbesondere -NH-,

x und x' unabhängig voneinander eine Zahl von 2 bis 4, bevorzugt je die Zahl 2,

Z Phenylen oder $C_{4-6}$-Cycloalkylen,

X die direkte Bindung, -O-, -S-, $-SO_2-$, $-CH_2-$ oder $-C(CH_3)_2-$ und

Y und Y' je -OH- oder zusammen -O- darstellen, wobei der Anteil an Bisimid der Formel II 0,1 bis 75 Gew.-%, bevorzugt 1 bis 25 Gew.-% bezogen auf das Polymer A), beträgt.

Durch R, R', $R_2$ und $R_3$ dargestellte Alkylgruppen können geradkettig oder verzweigt sein. Als Beispiele solcher Gruppen seien genannt: Methyl, Äthyl, n-Propyl, Isopropyl, n-Butyl und sek-Butyl. Bevorzugt sind

Alkylgruppen mit 1 oder 2 C-Atomen, vor allem Methyl.

Stellen R und R' zusammen eine Gruppierung der Formel III dar, so bedeuten E, $R_2$ und $R_3$ vorzugsweise Wasserstoff und A ist $-CH_2-$. Bevorzugt stellen R und R' zusammen Tetramethylen, 3- oder 4-Methyltetramethylen und vor allem je Methyl dar. Verbindungen der Formel II worin R und R' (Methyl)-Tetramethylen bedeuten sind neu und deren Verwendung ist ebenfalls Gegenstand vorliegender Erfindung.

Stellt $R_4$ $-C_mH_{2m}-$ dar, so kann es sich um geradkettige oder verzweigte Reste handeln, wie z. B. Methylen, Äthylen, 1,2- oder 1,3-Propylen, Tetramethylen, 1,1,3,3-Tetramethylbutylen, Pentamethylen, Hexamethylen, Heptamethylen, Octamethylen, Nonamethylen, Decamethylen, Undecamethylen, Tridecamethylen, Tetradecamethylen, Hexadecamethylen, Heptadecamethylen, Octadecamethylen und Eicosylen. Bevorzugt sind geradkettige Reste $-C_mH_{2m}$ - mit m = 2-10. Bedeutet $R_4$ eine Gruppe $-CH_2-Z-CH_2-$, so handelt es sich z. B. um die 1,3- oder 1,4-Phenylengruppe, 1,2-Cyclo-butylen-, 1,3-Cyclopentylen- oder 1,3-Cyclohexylengruppe. Bevorzugt stellt Z 1,3- oder 1,4-Phenylen, 1,3- oder 1,4-Cyclohexylen dar.

Bedeutet $R_4$ Phenylen, das durch ein oder zwei Chloratome oder eine oder zwei Methylgruppen substituiert sein kann, so kommen z. B. die 1,3- und 1,4-Phenylen-, o- oder m-Toluylen-, 4,5-Dimethyl-1,2-phenylen und 3-Chlor-1,4-phenylengruppein Betracht. Stellt $R_4$ eine Gruppe

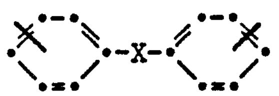 oder 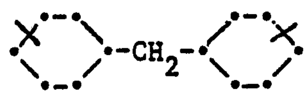 dar, so .

dar, so handelt es sich vor allem um den Rest des 4,4'-Diaminodiphenylmethans, 4,4'-Di-aminodiphenyläthers, 4,4'-Diaminodiphenylsulfids oder 4,4'-Diaminodicyclohexylmethans. $R_4$ stellt vorzugsweise geradkettiges $-C_mH_{2m}$ - mit m = 2-10, $-(CH_2)_2Q(CH_2)_2-$ mit Q = -S-, -O- und insbesondere -NH-, $-CH_2-Z-CH_2-$ mit Z = 1,3- oder 1,4-Phenylen, 1,3-oder 1,4-Cyclohexylen; den Rest des 4,4'-Diaminodiphenylmethans, 4,4'-Diaminodiphenyläthers oder 4,4'-Diaminodiphenylsulfids, 1,3-oder 1,4-Phenylen dar.

Ganz besonders bevorzugt sind Stoffgemische, worin R und R' je Methyl, $R_1$ Wasserstoff, Y und Y' zusammen -O- und $R_4$ $-(CH_2)_2NH(CH_2)_2-$ und vor allem geradkettiges $-C_mH_{2m}$ - mit m = 2-10 bedeuten.

Die erfindungsgemäss einzusetzenden Polymeren weisen vorzugsweise ein durchschnittliches Molekulargewicht von 1000 bis 1 000 000 und ganz besonders von 1000 bis 350 000 auf. Das durchschnittliche Molekulargewicht der Polymeren kann nach an sich bekannten Methoden, z. B. mittels Lichtstreuung, Dampfdruckosmometrie oder Ultrazentrifugation, bestimmt werden.

Geeignete ungesättigte Polykondensationsprodukte sind z. B. ungesättigte Polyamide, Polyester, Polyesteramide und Polyurethane.

Bevorzugt verwendet man Polykondensationsprodukte, die wiederkehrende Strukturelemente der Formeln IV bis X

$$-NH-CO-R_5-\overset{R_1}{\overset{|}{C}}=CH-R_6-CO-NH-R_7- \qquad (IV),$$

$$-R_8-CO-NH-R_9-CH=CH-R_{10}-NH-CO- \qquad (V),$$

$$-O-CO-R_5-\overset{R_1}{\overset{|}{C}}=CH-R_6-CO-O-R_{11}- \qquad (VI),$$

$$-CO-O-CH_2-CH=CH-CH_2-O-CO-R_8- \qquad (VII),$$

$$-CO-O-\underset{\underset{CH_2}{\overset{\|}{CH}}}{\underset{|}{CH}}-CH_2-O-CO-R_8- \qquad (VIII),$$

-NH-CO-O-$CH_2$-CH=CH-$CH_2$-O-CO-NH-$R_{11}$- (IX) oder

-O-CO-NH-$R_{12}$-CH=CH-$R_{13}$-NH-CO-O-$R_{11}$- (X)

und gegebenenfalls entsprechende gesättigte wiederkehrende Strukturelemente aufweisen, die durch teilweise Addition von Anhydriden der Formel XI

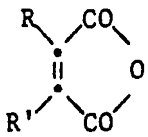 (XI)

an die C=C-Doppelbindungen der Ausgangspolymeren mit Strukturelementen der Formeln IV bis X und allfällige Hydrolyse der Anhydridgruppen erhalten werden, wobei R, R' und $R_1$ die unter Formel 1 angegebene Bedeutung haben,

$R_5$ und $R_6$ unabhänging voneinander die direkte Bindung oder -$CH_2$-, oder eines von $R_5$ und $R_6$ die direkte Bindung und das andere

-CH=CH- oder -(-$CH_2$-)-$_8$-,

$R_7$ den Rest eines aromatischen Diamins, besonders 1,3- oder 1,4-Phenylen, den Rest des 4,4'-Diaminodiphenylmethans oder 4,4'-Diaminodiphenyläthers oder den Rest eines aliphatischen Diamins mit 1-16 C-Atomen, besonders -$C_o H_{2o}$- mit o = 2-7,

$R_8$ den Rest einer aromatischen Dicarbonsäure, besonders den Rest der Terephthalsäure oder Isophthalsäure, oder den Rest einer gegebenenfalls C=C-Doppelbindungen aufweisenden aliphatischen Dicarbonsäure mit mindestens 6 C-Atomen, besonders -$(CH_2)_p$- mit p = 4-12 und vor allem 4-8,

$R_9$ und $R_{10}$ unabhängig voneinander gegebenenfalls substituierte und/oder C=C-Doppelbindungen aufweisende aliphatische Reste mit zusammen 4-12 C-Atomen in den Hauptketten,

$R_{11}$ den Benzolrest, 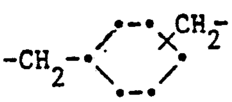 oder -$C_qH_{2q}$- mit q = 2-10, besonders 2-4, und

$R_{12}$ und $R_{13}$ unabhängig voneinander -$(CH_2)_r$-mit r = 1-5 darstellen.

In den Formeln IV und VI stellen $R_5$ und $R_6$ bevorzugt je die direkte Bindung dar und $R_1$ ist Methyl und insbesondere Wasserstoff oder $R_1$ ist Wasserstoff und $R_5$ und $R_6$ sind je -$CH_2$-. Ganz besonders bevorzugt ist $R_1$ in den Formeln IV und VI Wasserstoff und $R_5$ und $R_6$ stellen je die direkte Bindung dar.

Bei den genannten Polymeren kann es sich um Homo- oder Copolymere handeln, wie z. B. Copolyester aus Diolen HO-$R_{11}$-OH und Gemischen aus ungesättigten und gesättigten Dicarbonsäuren, wie Gemische aus Maleinsäureanhydrid und Terephthalsäure oder Derivaten davon.

Als Polyester werden solche bevorzugt, die aus wiederkehrenden Strukturelementen der Formel VIa

-O-CO-CH=CH-CO-O-$R_{11}$- (VIa)

und gegebenenfalls wiederkehrenden Strukturelementen der Formel VIb und/oder Ia

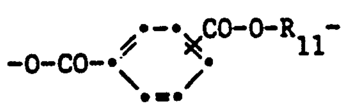 (VIb)

und/oder 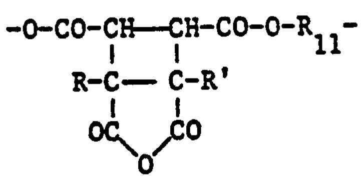 (Ia)

bestehen, worin R und R' zusammen Tetramethylen und vor allem je Methyl,

$R_{11}$ eine Gruppe 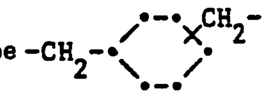, besonders 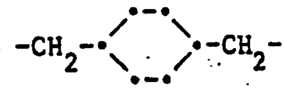, oder

$-CH_2)_s-$ mit s = 2-12, besonders 2-4, darstellen. Der Anteil an Strukturelementen der Formel Ia kann bis zu 95 %, insbesondere 30 bis 85 %, bezogen auf die Gesamtzahl der wiederkehrenden Strukturelemente des Polyesters, betragen. Bevorzugt sind Polyester, die aus Strukturelementen der Formel VIa und gegebenenfalls Strukturelementen der Formel VIb bestehen.

Ganz besonders bevorzugt verwendet man Polyamide, die aus wiederkehrenden Strukturelementen der Formel Va

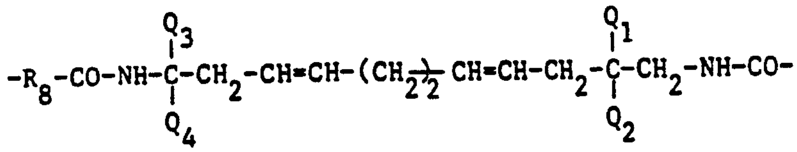 (Va)

und gegebenenfalls wiederkehrenden Strukturelementen der Formeln Ib, Ic und/oder Id

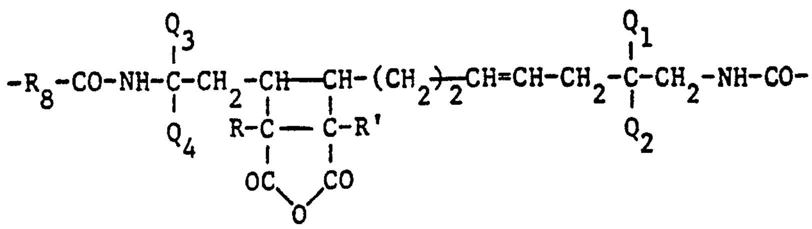 (Ib) ,

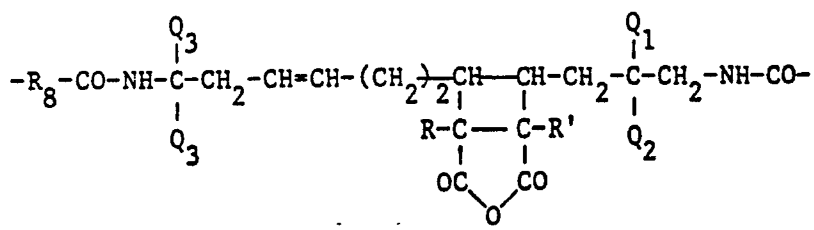 (Ic) ,

und/oder

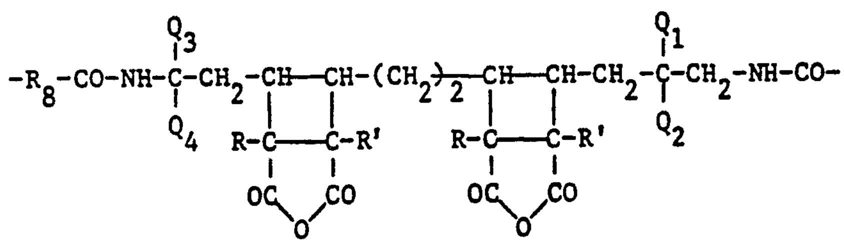 (Id)

bestehen, worin R und R' zusammen Tetramethylen und vor allem je Methyl,

Q $C_{1-12}$-Alkyl,

$Q_2$ Wasserstoff oder $C_{1-12}$-Alkyl,

$Q_3$ $C_{1-12}$-Alkyl, Cycloalkyl mit 4-12 Ring-C-Atomen, Aralkyl mit 7 oder 8 C-Atomen oder Phenyl und

$Q_4$ Wasserstoff $C_{1-12}$-Alkyl, Cycloalkyl mit 4-12 Ring-C-Atomen, Aralkyl mit 7 oder 8 C-Atomen oder Phenyl oder

$Q_1$ und $Q_2$ und/oder $Q_3$ und $Q_4$ zusammen Alkylen mit 3-11 C-Atomen bedeuten und

$R_8$ den Rest der Terephthalsäure, Isophthalsäure und/oder einer gesättigten aliphatischen Dicarbonsäure mit 6-12 C-Atomen darstellt. Der Anteil an Strukturelementen der Formeln Ib, Ic und/oder Id kann bis zu 95 %, insbesondere 20-90 %, bezogen auf die Gesamtzahl der wiederkehrenden Strukturelemente des Polyamids, betragen.

Vorzugsweise bedeuten $Q_1$ $C_{1-5}$-Alkyl, $Q_2$ Wasserstoff oder $C_{1-15}$-Alkyl oder $Q_1$ und $Q_2$ zusammen Alkylen mit 4-7 C-Atomen, $Q_3$ $C_{1-7}$-Alkyl, $C_{5-8}$-Cycloalkyl oder Phenyl, besonders $C_{1-5}$-Alkyl oder Phenyl, und $Q_4$ Wasserstoff oder $C_{1-5}$-Alkyl, besonders Wasserstoff oder Methyl.

Besonders bevorzugt sind $Q_1$ Methyl oder Äthyl, $Q_2$ Wasserstoff, Methyl oder Äthyl, $Q_3$ $C_{1-5}$-Alkyl oder Phenyl, $Q_4$ Wasserstoff oder Methyl und $R_8$ bedeutet den Rest der Terephthalsäure, Isophthalsäure und/oder einer gesättigten aliphatischen Dicarbonsäure mit 6-10 C-Atomen.

Ganz besonders bevorzugt sind Polymere aus wiederkehrenden Strukturelementen der Formel Va und gegebenenfalls wiederkehrenden Strukturelmenten der Formeln Ib, Ic und/oder Id, worin R und R' zusammen Tetramethylen und vor allem je Methyl, $Q_1$ und $Q_2$ Methyl, $Q_3$ Isopropyl, $Q_4$ Wasserstoff und $R_8$ den Rest der Terephthalsäure, Isophthalsäure und/oder Adipinsäure darstellen, vor allem solche, worin $Q_1$ und $Q_2$ Methyl, $Q_3$ Isopropyl, $Q_4$ Wasserstoff und $R_8$ den Rest der Terephthalsäure und/oder den Rest der Adipinsäure bedeuten, wobei der Anteil an Strukturelementen der Formeln Ib, Ic und/oder Id bis zu 40-85 %, bezogen auf die Diaminkomponenten des Polyamids, betragen kann. Am meisten bevorzugt sind Polyamide, die nur aus wiederkehrenden Strukturelementen der Formel Va bestehen, worin $Q_1$ bis $Q_4$ und $R_8$ die oben angegebenen bevorzugten Bedeutungen haben.

Aliphatisch ungesättigte Polykondensationsprodukte, die wiederkehrende Strukturelemente der Formel I aufweisen, sind neu und der Verwendung ist ebenfalls Gegenstand vorliegender Erfindung. Dabei gilt in Bezug auf bevorzugte Bedeutungen von $R_1$, R, R', Y und Y' sowie bevorzugte ungesättigte Polykondensationsprodukte, die teilweise mit Gruppen FIGURFIGUR

modifiziert sind, das oben Angegebene. Polymere mit Strukturelementen der Formel I können dadurch erhalten werden, dass man aliphatisch ungesättigte Polykondensationsprodukte radikalisch oder unter Lichteinwirkung mit einer Verbindung der Formel XI umsetzt und gegebenenfalls die Anhydridgruppen hydrolysiert. Die Umsetzung wird zweckmässig in Inertgasatmosphäre, z. B. unter Stickstoff, und in Gegenwart eines inerten organischen Lösungsmittels und eines Sensibilisators der nachfolgend beschriebenen Art durchgeführt. Als Lösungsmittel eignen sich z. B. aliphatische, cycloaliphatische oder aromatische, gegebenenfalls halogenierte Kohlenwasserstoffe, wie Pentan, Hexan, Heptan, Cyclohexan, Benzol, Toluol, Chlorbenzol, Dichlorbenzole; cyclische oder aliphatische Amide, wie N-Methylpyrrolidon, N-Äthyl-2-pyrrolidon, N-Methyl-ε-caprolacatam, N,N-Dimethylformamid, N,N-Dimethylacetamid, N,N-Diäthylacetamid; aliphatische und cyclische Ketone, wie Aceton, Methyläthylketon, Cyclohexanon und Cyclopentanon; Alkohole, wie Methanol, Äthanol und 2-Methoxyäthanol. Es können auch Gemische der genannten Lösungsmittel verwendet werden. Bevorzugtes Lösungsmittel ist N,N-Dimethylformamid.

Die Verbindungen der Formel XI sowie die Polymeren mit Strukturelementen der Formeln IV bis X sind bekannt oder können nach an sich bekannten Methoden hergestellt werden. Verbindungen der Formel II können auf an sich bekannte Weise durch Umsetzung einer Verbindung der Formel XI mit Diaminen $H_2N-R_4-NH_2$ und Cyclisierung der intermediär entstehenden Amidsäuren erhalten werden. Die Verbindungen der Formel II, worin R und R' zusammen gegebenenfalls durch eine Methylgruppe substituiertes Tetramethylen darstellen und $R_4$ die angegebene Bedeutung hat, sind neu und ein weiterer Gegenstand der vorliegenden Erfindung. Dabei gilt in bezug auf bevorzugte Bedeutungen von $R_4$ das oben Angegebene und R und R' stellen bevorzugt zusammen Tetramethylen dar. Die für die Herstellung von Polymeren mit wiederkehrenden Strukturelementen der Formel V benötigten ungesättigten Diamine können z. B. dadurch erhalten werden, dass man Oxime der Formel XII

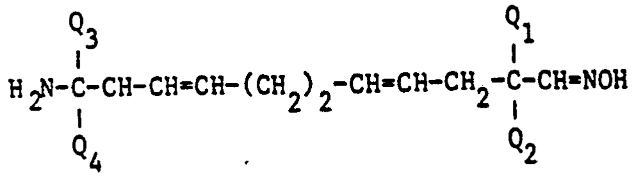

(XII)

direkt zu den entsprechenden Diaminen reduziert oder die Oxime zuerst zu den entsprechenden Nitrilen dehydratisiert und die Nitrile zu den Diaminen reduziert. Die Oxime der Formel XII sind bekannt oder können nach dem in der europäischen Patentanmeldung Veröff. Nr. 11599 beschriebenen Verfahren hergestellt werden.

Die erfindungsgemässen Stoffgemische können neben den Sensibilisatoren übliche Zusätze enthalten, wie weitere Vernetzungsmittel. Als zusätzliche Vernetzungsmittel kommen insbesondere Diamine, z. B. solche der in der deutschen Offenlegungsschrift 26 57 104 beschriebenen Art, in Betracht. Als Sensibilisatoren eignen sich insbesondere Triplettsensibilisatoren, bei deren Anwendung die Reaktion durch Triplettenergietransfer des angeregten Sensibilisators auf die nicht angeregten Verbindungen der Formel II erfolgt, wie z. B. Ketone,

beispielsweise Acetophenon, Benzophenon, Aceton, Methyläthylketon, Methylisobutylketon, Michler's Keton, 1,2- Dibenzilbenzol, 1,4-Diacetylbenzol, 4-Cyanobenzophenon, Thioxanthone, Anthrachinon, 1,2- und 1,4-Naphthochinon, 2-Methylanthrachinon, Benzanthron, Violanthron, p,p'-Tetramethyldiaminobenzophenon, Chloranil; Anthracen, Chrysen; Nitroverbindungen, wie Nitrobenzol, p-Dinitrobenzol, 1- oder 2-Nitronaphthalin, 2-Nitrofluoren, 5-Nitroacenaphthen, Nitroanilin, 2-Chlor-4-nitroanilin, 2,6-Dichlor-4-nitroanilin. Als Sensibilisatoren können auch Radikal-Initiatoren, wie Azoisobutyronitril oder Peroxide, z. B. Dibenzoylperoxid, eingesetzt werden. Bevorzugt verwendet man als Sensibilisatoren unsubstituiertes Thioxanthon oder substituierte Thioxanthone, z. B. solche der in den deutschen Offenlegungsschrift 30 18 891 und 31 17 568 sowie der europäischen Patentanmeldung Veröff. Nr. 33720 beschriebenen Art.

Gegenstand der Erfindung sind auch die vernetzten Produkte, die dadurch erhältlich sind, dass man ein definitionsgemässes Stoffgemisch in Gegenwart eines Sensibilisators und gegebenenfalls in Gegenwart eines weiteren Vernetzungsmittels unter Lichteinwirkung vernetzt. Als Sensibilisatoren kommen z. B. solche der oben erwähnten Art in Betracht.

Für die Belichtung bei den Vernetzungsreaktionen wie auch bei der allfälligen vorausgehenden Umsetzung der Polymeren mit den Anhydriden der Formel XI wird vorzugsweise UV-Licht verwendet. Als Lichtquellen eignen sich z. B. Xenonlampen, Kohlelichtbögen, Quecksilberlampen und Metallhalogenid-Quecksilberlampen.

Die erfindungsgemässen Stoffgemische eignen sich z. B. zur Herstellung von lösungsmittelbeständigen Beschichtungen und Überzügen auf verschiedenen Substraten, vor allem Metallen, wie Aluminium, Kupfer und Stahl, oder Kunststoffen, z. B. Polyestern, Celluloseacetat und dergl., oder zur Herstellung von Druckplatten für das Offsetdruckverfahren, zur Herstellung von Photooffset-Lacken, für die unkonventionelle Photographie, z. B. zur Herstellung von gegebenenfalls mit kationischen Farbstoffen gefärbten photographischen Bildern mittels Photovernetzung. Bevorzugt werden sie zur Herstellung von Druckplatten oder als sogenannte Photoresistmaterialien zur Herstellung von gedruckten Schaltungen nach an sich bekannten Methoden verwendet. Bei der letzteren Anwendung wird die mit der lichtempfindlichen Schicht versehene Seite der Leiterplatte durch eine das Leiterbild aufweisende Photomaske belichtet und dann entwickelt, worauf man die unbelichteten Stellen der Schicht durch Entwicklungsflüssigkeit herausholt. Stoffgemische, in denen das Polymere Strukturelemente der Formel I aufweist, sind wässrig oder wässrig-alkalisch entwickelbare Systeme, was aus ökologischen Gründen im Vergleich zu bestimmten Entwicklungsbädern auf der Basis von organischen Lösungsmitteln vorteilhaft sein kann. Derartige Systeme können auch mit kationischen Farbstoffen gefärbt werden. Die Trägermaterialien können nach an sich üblichen Techniken mit den lichtempfindlichen Stoffgemischen beschichtet werden, z. B. durch Tauchverfahren, Sprüh-, Schleuder-, Kaskaden, Rakel- oder Vorhangguss oder sogenanntes "roller-coating".

Die erfindungsgemässen Stoffgemische zeichnen sich vor allem durch eine hohe Lichtempfindlichkeit aus. Die damit erhältlichen vernetzten Produkte weisen eine gute Lösungsmittelbeständigkeit, z. B. in Isopropanol, eine hohe Abriebfestigkeit und eine gute Haftung auf verschiedenen Trägermaterialien, besonders Metallen, auf.

**Beispiele 1-5:**

Zu einer Lösung von 5,0 g eines Polyamids aus Adipinsäure und 2,2-Dimethyl-11-isopropyl-1,11-diaminoundeca-4,8-dien (DUD) in 70 ml N,N-Dimethylformamid (DMF) in einem UV-Reaktor (Kolben, der mit einer 125 W HPK Philips Tauchlampe ausgerüstet ist) werden jeweils die in der folgenden Tabelle I angegebenen Mengen Dimethylmaleinsäureanhydrid und 0,25 g Thioxanthon in 80 ml DMF unter Stickstoffatmosphäre und Belichtung bei 20°C während 2 Std. zugetropft. Dann wird die Lösung noch 20 Stunden belichtet und auf ein Drittel des Volumens eingeengt. Das Polymere wird durch Eingiessen in 2 Liter Diäthyläther ausgefällt. Die analytischen Daten der erhaltenen Polymeren sind in Tabelle I zusammengefasst.

Das verwendete Polyamid kann wie folgt hergestellt werden:

62,8 g 2,2-Dimethyl-11-isopropyl-1,11-diamino-undeca-4,8-dien, 36,4 g Adipinsäure, 0,25 ml einer 10 %-igen wässrigen $NH_4H_2PO_2$-Lösung und 0,5 g Di-tert-butyl-p-kresol werden in einem Autoklaven 90 Minuten in Stickstoffatmosphäre vorkondensiert, dann 4 Stunden in einem offenen Polykondensationsgefäss im Stickstoffstrom weiterkondensiert und schliesslich 1 Stunde im Hochvakuum nachkondensiert. Alle Polykondensationsschritte werden bei 250°C durchgeführt. Elementaranalyse des erhaltenen Polyamids:

| | | | |
|---|---|---|---|
| berechnet | C 72,88 % | H 10,57 % | N 7,73 % |
| gefunden | C 70,20 % | H 10,47 % | N 7,45 %. |

Endgruppengehalt: -COOH 0,16m/Äquiv./g; $-NH_2$ 0,04 m/Äquiv./g. Glasumwandlungstemperatur (Tg, bestimmt im Differentialscanningkalorimeter) = 45°C; reduzierte Viskosität $\eta_{red.}$ = 0,70 dl/g (gemessen als 0,5 %-ige Lösung in m-Kresol bei 25°C).

Das verwendete Diamin kann wie folgt hergestellt werden:

80 g (0,3 Mol) 2,2-Dimethyl-11-isopropyl-11-amino-undeca-4,8 dienaloxim werden unter Rühren mit 100 ml Eisessig versetzt. Dann wird HCl-Gas bis zur Sättigung eingeleitet, und innerhalb von 15 Minuten werden 30,6 g (0,3 Mol) Essigsäureanhydrid zugetropft. Man erhitzt die Reaktionsmischung noch 4 Stunden unter Rückfluss,

destilliert den Eisessig ab und löst den Rückstand in Wasser. Nachdem man die Lösung mit Natronlauge basisch gestellt hat, nimmt man die sich abscheidende organische Phase mit Toluol auf und destilliert. Man erhält 68,5 g (0,276 Mol) 1,1-Dimethyl-10-isopropyl-10-amino-deca-3,7-dien-nitril, entsprechend einer Ausbeute von 92 % d. Th.; Sdp. 94°C/3 Pa.

23 g (1 Mol) Natrium werden zu 150 ml Toluol gegeben, und die Mischung wird bis zum Schmelzen des Natriums aufgeheitzt. Dann wird die Heizung entfernt und solange gerührt, bis das Natrium als feingraue Dispersion zerteilt ist. Zu dieser Mischung tropft man dann eine Lösung von 53 g (0,214 Mol) 1,1-Dimethyl-10-isopropyl-10-amino-deca-3,7-dien-nitril in 100 ml Isopropanol. Es wird noch 3 Stunden unter Rückfluss gekocht, mit 200 ml Wasser versetzt, und die organische Phase wird abgetrennt. Nach dem Abdestillieren des Lösungsmittels erhält man 44 g (0,175 Mol) 2,2-Dimethyl-11-isopropyl-1,11-diamino-undeca-4,8-dien, entsprechend einer Ausbeute von 81,5 % d. Th.; Sdp. 86°C/l Pa; $n_D^{20}$ = 1,4810.

**Tabelle I**

| | | | Polymer-Endprodukt | | | | | |
|---|---|---|---|---|---|---|---|---|
| Beispiel Nr. | Menge an eingesetztem Dimethylmaleinsäureanhydrid (g/% bezogen auf Doppelbindungen im Polymer) | Glasumwandlungstemp. Tg °C | η (dl/g)1) | C % | H % | N % | Gesamtsäuregehalt m.Äquiv./g | Umsatz DUD (%)2) |
| 1 | 1,73 g/50 % | 53 | 0,49 | 66,93 | 9,45 | 7,00 | 2,77 | 42,55 |
| 2 | 2,07 g/60 % | 40 | 0,46 | 66,80 | 9,08 | 7,00 | 3,11 | 47,77 |
| 3 | 2,59 g/75 % | 56 | 0,39 | 66,75 | 8,90 | 6,50 | 3,39 | 52,07 |
| 4 | 3,46 g/100 % | 83 | 0,48 | 66,80 | 8,70 | 5,50 | 4,98 | 77,33 |
| 5 | 4,15 g/120 % | 90 | 0,47 | 66,00 | 8,28 | 5,29 | 5,37 | 83,39 |

1) 0,5 %-ige Lösung in m-Kresol bei 25°C
2) umgesetzte Doppelbindungen im Polymer in % (100 % = 6,44 m.Äquiv./g)

**Beispiel 6:**

Zu einer Lösung von 5,0 g des in Beispiel 1 beschriebenen Ausgangspolyamids in 70 ml DMF in einem Kolben, der mit Magnetrührer, Stickstoff-Ein- und -Auslass und einer 125 W HPK Philips-Tauchlampe ausgerüstet ist, werden unter Durchleiten von Stickstoff bei 20°C nach dem Einschalten der Lampe 4,20 g 3,4,5,6-Tetrahydro-phthalsäureanhydrid und 0,25 g Thioxanthon in 80 ml DMF während 2,5 Std. zugetropft. Anschliessend wird die Lösung unter Stickstoff noch 15,5 Std. bestrahlt. Die Hälfte des Lösungsmittels wird abgezogen. Zu der verbleibenden Lösung gibt man 10 ml Wasser, erwärmt während 5 Minuten auf 80°C und kühlt ab. Das Produkt wird in 2 Liter Diäthyläther gefällt. Das ausgefallene Produkt wird abfiltriert und bei 20°C im Vakuum getrocknet. Ausbeute an Polyamid: 7,94 (Umsatz 70,0 %); $\eta_{red.}$ = 0,29 dl/g (0,5 %-ige Lösung in m-Kresol bei 25°C); Tg = 55°C. Elementar-Analyse: C 65,90 % H 8,70 % N 5,86 %.

Totalsäuregehalt im Polymeren: 3,98 m.Äquiv./g, was einer 66,3 %-igen Umsetzung der C=C-Doppelbindungen im Polymeren durch das 3,4,5,6-Tetrahydrophthalsäureanhydrid entspricht.

**Beispiele 7-9:**

0,3 g des Polyamids gemäss Beispiel 2 (mit Dimethylmaleinsäureanhydrid modifiziert), 17 mg Thioxanthon und jeweils die in der folgenden Tabelle II angegebene Menge an N,N'-Äthylen-bis-dimethylmaleinimid werden in 7,0 g DMF gelöst. Die Lösung wird mit einem 75 µm-Rakel auf eine Kupfer-Leiterplatte aufgetragen und 4 Minuten bei 100°C getrocknet. Dann wird die Beschichtung durch eine photographische Maske mit einem Stufenkeil (21 Step Sensitivity Guide der Fa. Stouffer) im Abstand von 70 cm mit einem 5000 W Hochdruckbrenner belichtet, anschliessend während 30 Sekunden in 5 %-ige NaoH eingetaucht, kurz mit deionisiertem Wasser gewaschen, während 30 Sekunden in 5 %-ige HCl getaucht und in $FeCl_3$-Lösung geätzt. Die Belichtungszeiten und die entsprechenden auf dem Stufenkeil abgebildeten Stufen sind in Tabelle II angegeben.

**Tabelle II**

| Biespel Nr. | eigesetztes Bis-maleinimid (mg/Gew.-%) | Belichtungszeit (Sek.) | letzte abgebildete Stufe |
|---|---|---|---|
| 7 | 60 mg/20 Gew.-% | 30 | 2 |
| | | 60 | 3 |
| | | 129 | 6 |
| 8 | 30 mg/10 Gew.-% | 30 | 2 |
| | | 60 | 3 |
| | | 120 | 6 |
| 9 | 15 mg/5 Gew.-% | 30 | keine |
| | | 60 | 2 |
| | | 120 | 4 |

**Beispiel 10:**

0,5 g des in Beispiel 1 beschriebenen Ausgangspolyamids, 0,25 g N,N'-Octamethylen-bis-dimethylmaleinimid und 40 mg Thioxanthon werden in einem Gemisch von 4,5 g Methylcellosolve, 2,25 g Methyläthylketon und 1 g Chloroform (Verhältnis 6 : 3 : 1 gelöst. Mit der Lösung wird eine Kupfer-Leiterplatte mit Hilfe eines 50 µm-Rakels beschichtet und 3 Minuten bei 100°C getrocknet. Dann wird die Beschichtung durch einen Stufenkeil der in den Beispielen 7-9 beschriebenen Art mit einem 5000 W Hochdruckbrenner belichtet und im oben beschriebenen Lösungsmittelgemisch während 30 Sekunden entwickelt. Es werden die folgenden Resultate erzielt:

| Belichtungszeit (Sek.) | letzte abgebildete Stufe |
|---|---|
| 300 | 10 |
| 420 | 12. |

**Beispiel 11:**

0,5 g eines Polyesters aus 100 Gew.teilen 1,3-Propylen-glykol, 72 Gew.teilen Maleinsäureanhydrid und 54 Gew.teilen Phthalsäureanhydrid mit einer Viskosität von 1000 mPa s bei 20°C, 0,25 g N,N'-Octamethylen-bis-dimethylmaleinimid und 37 mg Thioxanthon werden in 6,75 g Chloroform gelöst. Mit der Lösung wird eine Kupfer-Leiterplatte mit Hilfe eines 50 µ-Rakels beschichtet und 3 Minuten bei 100°C getrocknet. Die erhaltene Beschichtung ist transparent und glänzend. Die Beschichtung wird anschliessend durch einen Stufenkeil der oben beschriebenen Art in einer Entfernung von 70 cm mit einem 5000 W Hochdruckbrenner belichtet und während 1 Minute in einem Lösungsmittelgemisch aus Chloroform/Äthanol (1 : 1) entwickelt.
Es werden die folgenden Resultate erzielt:

| Belichtungszeit (Sek.) | letzte abgebildete Stufe |
|---|---|
| 90 | 4 |
| 180 | 6. |

Das Verhältnis der Doppelbindungen im Ausgangspolymeren zu dem Bisimid beträgt 0,6.

**Beispiel 12:**

1,0 g des gemäss Beispiel 2 hergestellten, mit Dimethylmaleinsäureanhydrid modifizierten Polyamids, 0,20 g N,N'-Octamethylen-bis-dimethylmaleinimid und 60 mg Thioxanthon werden in 24 g Chloroform gelöst. Die Lösung wird mit einem 50 µm-Rakel auf eine Kupfer-Leiterplatte aufgetragen und 4 Minuten bei 100°C getrocknet. Die Beschichtung wird durch einen Stufenkeil der oben beschriebenen Art im Abstand von 70 cm mit einem 5000 W Hochdruckbrenner 30 Sekunden belichtet, dann bei 30°C während 30 Sekunden in 5 %-ige NaOH eingetaucht, kurz mit deionisiertem Wasser gewaschen, während 30 Sekunden in 5 %-ige HCl eingetaucht und in einer $FeCl_3$-Lösung geätzt.

Letzte abgebildete Stufe: 6. Das Bild ist gut ätzbar.

**Beispiel 13:**

0,5 g gemäss Beispiel 1 hergestellten, mit Dimethylmaleinsäureanhydrid modifizierten Polyamids, 50 bzw. 100 mg des Bisimids der Formel

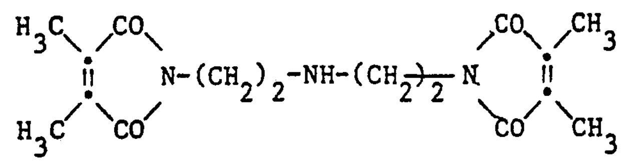

und 30 mg Thioxanthon werden in 9,5 g DMF gelöst. Die Lösung wird mit einem 24 µm-Rakel auf eine Kupfer-Leiterplatte aufgetragen und 4 Minuten bei 125°C getrocknet. Die Beschichtung wird durch einen Stufenkeil der oben beschriebenen Art mit einem 5000 W Hochdruckbrenner in einem Abstand von 70 cm 30 Sekunden belichtet, anschliessend während 1 Minute in 5 %-ige NaOH eingetaucht, dann während 30 Sekunden in 5 %-ige HCl getaucht und in $FeCl_3$-Lösung geätzt.

Letzte abgebildete Stufe bei Verwendung von 50 mg Bisimid: 2

Letzte abgebildete Stufe bei Verwendung von 100 mg Bisimid: 1.

**Beispiele 14-16:**

0,5 g eines Polyamids aus 2,2-Dimethyl-11-isopropyl-1,11-diaminoundeca-4,8-dien und Adipinsäure [auf analoge Weise hergestellt wie in den Beispielen 1-5 beschrieben; Tg = 58°C, $\eta_{red.}$ = 0,65 dl/g, 5 %-ige Lösung in m-Kresol bei 25°C], jeweils 50 mg der folgenden Bis-imide:

A) Gemisch aus N,N'-Hexamethylen-bis-(3-methyl-3,4,5,6-tetrahydrophthal-imid) und N,N'-Hexamethylen-bis-(4-methyl-3 4,5,6-tetrahydrophthalimid (Verhältnis ca. 15,85 Gew.-%).
B) N,N'-Hexamethylen-bis-3,4,5,6-tetrahydrophthalimid,
C) N,N'-Hexamethylen-bis-dimethylmaleinimid,

sowie 27,5 mg Thioxanthon-7-methyl-3-carbonsäureäthylester werden in 11 g Chloroform gelöst. Mit der erhaltenen Lösung wird mit einem 50 µm-Rakel eine Kupfer-Leiterplatte beschichtet und 3 Minuten bei 80°C getrocknet. Die Beschichtung wird in einem Abstand von 70 cm mit einem 5000 W Hochdruckbrenner durch einen Stufenkeil der Fa. Stouffer (21 Step Sensitivity Guide) belichtet. Die nicht belichteten Anteile werden durch Waschen in Chloroform (30 Sekunden) herausgelöst. Die Resultate sind in der folgenden Tabelle III angegeben.

**Tabelle III**

| Belichtungs-zeit (Sek.) | letzte abgebildete Keilstufe unter Verwendung von Bis-imid | | |
|---|---|---|---|
| | A (Bsp. 14) | B (Bsp. 15) | C (Bsp. 16) |
| 15 | keine | 1 | 2 |
| 30 | keine | 3 | 4 |
| 45 | 1 | 4 | 5 |
| 120 | 4 | 7 | 9 |

Die in den obigen Beispielen 14 und 15 verwendeten neuen Bisimide A) und B) können wie folgt hergestellt werden:

a) 23,2 g (0,2 Mol) 1,6-Diaminohexan und 66,4 g (0,4 Mol) eines Gemisches aus ca. 15 Gew.-% 3-Methyl-1-cyclohexen-1,2-dicarbonsäureanhydrid und ca. 85 Gew.-% 4-Methyl-1-cyclohexen-1,2-dicarbonsäure-anhydrid werden in 350 ml Toluol gelöst. Unter Rückfluss wird das entstandene Wasser während 24 Stunden abgeschieden. Danach werden 300 ml Toluol abdestilliert, die entstandenen Kristalle werden filtriert, mit Cyclohexan gewaschen, und das Rohprodukt wird aus Methanol umkristallisiert. Man erhält 35 g (42,5 % d.Th.)

eines Gemisches aus ca. 15 Gew.-% N,N'-Hexamethylen-bis-(3-methyl-3,4,5,6-tetrahydrophthalimid) und ca. 85 Gew.-% N,N'-Hexamethylen-bis-(4-methyl-3,4,5,6- tetrahydrophthalimid). Smp. 93-95° C.

Elementaranalyse:

| | | | |
|---|---|---|---|
| berechnet | C 69,88 | H 7,82 | N 6,79 % |
| gefunden | C 70,0 | H 7,8 | N 6,7 %. |

Dünnschichtchromatogramm: Lösungsmittel Toluol/Äthanol im Vol. Verhältnis 80 : 20 : 1 Hauptfleck.

b) 23,2 g (0,2 Mol) 1,6-Diaminohexan und 60,8 g (0,4 Mol) 1-Cyclohexen-1,2-dicarbonsäureanhydrid werden in 350 ml Toluol gelöst, und das gebildete Wasser wird unter Rückfluss während 20 Stunden abgeschieden. Dann werden 300 ml Toluol abdestilliert, und das ausgefallene Produkt wird filtriert, mit Toluol/Cyclohexan gewaschen und aus 600 ml Methanol umkristallisiert. Das erhaltene weisse kristalline Produkt wird im Vakuum bei 60°C 24 Stunden getrocknet. Man erhält 50 g (64,1 % d.Th.) N,N'-Hexamethylen-bis-3,4,5,6-tetrahydrophthalimid; Smp. 123-124°C.

Elementaranalyse:

| | | | |
|---|---|---|---|
| berechnet | C 68,73 % | H 7,34 % | N 7,4 % |
| gefunden | C 68,9 % | H 7,4 % | N 7,4 %. |

Dünnschichtchromatogramm: Lösungsmittel Toluol/Äthanol (Vol.Verhältnis 80 : 20): 1 Fleck.

**Beispiel 17:**

a) 72 g Adipinsäurediphenylester, 21,26 g cis-2-Buten-1,4-diol und 200 ppm Titantetraisopropylat werden in einen Kolben gegeben, der mit Stickstoffein- und -auslass, Kühler und Rührer ausgestattet ist. Dann wird mehrmals mit Stickstoff gespült, und der Kolben wird während 30 Stunden von 150 auf 250°C aufgeheitzt. Anschliessend wird die Temperatur noch 3 weitere Stunden bei 250°C gehalten. Nach Abkühlen der entstandenen Schmelze werden 150 ml DMF zugegeben, das Produkt wird in 3,5 Liter Diäthyläther gefällt, das ausgefallene Produkt wird abfiltriert, mit Diäthyläther gewaschen und bei 35°C im Vakuum getrocknet. Ausbeute: 36 g (97,74 % d.Th.): Tg = 40°C. Elementaranalyse: berechnet C 60,6 H 7,12 %, gefunden C 61,0 H 7,05 %.$\eta_{red.}$ 0,32 dl/g (0,5 %-ige Lösung in m-Kresol bei 25°C).

b) 5,0 g des gemäss a) erhaltenen Polymers und 60 ml DMF werden in ein Reaktionsgefäss gegeben, das mit einer 125 W HPK Philips Quecksilberhochdrucklampe, Stickstoffein- und -auslass, Rückflusskühler, Tropftrichter und Magnetrührer ausgestattet ist. Unter Stickstoff tropft man bei 25°C während 3 Std. eine Lösung von 2,38 g Dimethylmaleinsäureanhydrid und 250 mg Thioxanthon-7-methyl-3-carbonsäure-äthylester in 80 ml DMF zu. Dann wird die Lösung noch 18 Stunden bestrahlt. Es werden 25 ml Wasser zugegeben, und die Temperatur wird 3 Std. bei 90°C gehalten. Anschliessend wird das Polymer in 3 Liter Diäthyläther gefällt und im Vakuum bei 25°C getrocknet. Ausbeute 7,2 g. Tg = -29°C. Elementaranalyse: gefunden C 56,8 H 7,06 %. $\eta_{red.}$ = 0,22 dl/g (0,5 %-ige Lösung in m-Kresol bei 25°C). Gesamtsäuregehalt: 2,77 mÄquiv./g (entspricht einer ca. 80 %-igen Besetzung der C=C-Doppelbindungen).

c) 0,5 g des gemäss b) erhaltenen Polymers, 50 mg N,N'-Hexamethylen-bis-dimethylmaleinimid und 27,5 mg Thioxanthon-7-methyl-3-carbonsäure-äthylester werden in 11 ml Chloroform gelöst und mit einem 50 µm-Rakel auf eine Kupfer-Leiterplatte aufgetragen. Die Beschichtung wird 3 Minuten bei 80°C getrocknet und dann im Abstand von 70 cm während 10 Minuten durch einen Stufenkeil der in den vorangehenden Beispielen beschriebenen Art mit einer 5000 W Hochdrucklampe belichtet. Die unbelichteten Teile werden wärhend 30 Sekunden mit 5 %-iger $Na_2CO_3$-Lösung ausgewaschen. Letzte abgebildete Keilstufe: 3.

**Beispiel 18:**

a) 20,0 g Maleinsäureanhydrid, 29,42 g 1,4-Bis-(hydroxymethyl)-cyclohexan und 1,24 g p-Toluolsulfonsäure werden in 225 ml Benzol suspendiert und unter Wasserabscheidung 6,5 Stunden zum Rückfluss erhitzt. Nach dem Abkühlen der Lösung wird das ausgefallene Produkt abfiltriert, mit Benzol gewaschen und bei 20°C im Vakuum getrocknet. Ausbeute an Polyester: 42 g (92 % d.Th.). Tg = 40°C. Elementaranalyse: berechnet C 64,27 H 7,19 %, gefunden C 63,60 H 7,07 % $\eta_{red.}$ = 0,40 dl/g (0,5 %-ige Lösung in m-Kresol bei 25°C).

b) 5,0 g des gemäss a) hergestellten Polyesters werden in 330 g DMF gelöst und in ein Reaktionsgefäss der

in Beispiel 17 b) beschriebenen Art gegeben. Unter Stickstoff wird bei 25°C im Verlaufe von 3 Stunden eine Lösung von 2,11 g Dimethylmaleinsäureanhydrid und 250 mg Thioxanthon-7-methyl-3-carbonsäureäthylester in 147 g DMF zugetropft. Nach dem Einengen der Lösung auf 100 ml wird das Polymere in 2 Liter Diäthyläther gefällt und bei 25°C im Vakuum getrocknet. Ausbeute: 6,8 g. Tg = 57°C. Elementaranalyse: gefunden C 59,0 H 7,6 %. $\eta_{red.}$ = 0,22 dl/g (0,5 %-ige Lösung in m-Kresol bei 25°C). Gesamtsäuregehalt: 0,98 mÄquiv/g, was einer ca. 22 %-igen Besetzung der C=C-Doppelbindungen des Polymeren entspricht.

Je 0,5 g der gemäss a) und b) erhaltenen Polyester, 27,5 mg Thioxanthon-7-methyl-3-carbonsäureäthylester und 50 mg N,N'-Hexamethylen-bis-dimethylmaleinmid werden in 11 g DMF [für Polyester gemäss a)] bzw. Chloroform [für Polyester gemäss b)] gelöst. Mit diesen Lösungen werden mit einem 50 µm-Rakel Kupfer-Leiterplatten beschichtet und 3 Minuten bei 90°C getrocknet. Die Belichtung erfolgt mit einer 5000 W Hochdrucklampe im Abstand von 70 cm durch einen Stufenkeil der oben beschriebenen Art. Die Resultate und Einzelheiten über die Entwicklung sind unten angegeben.

| Polyester | Belichtungs-zeit (Min.) | Entwicklungs-lösung | Entwicklungs-zeit (Min.) | letzte ab-gebildete Keilstufe |
|---|---|---|---|---|
| a | 2 | DMF | 0,25 | 9 |
| | 10 | DMF | 0,25 | 14 |
| b | 2 | 5 %-ige NaOH | 25 | 1 |
| | 5 | 5 %-ige NaOH | 25 | 4 |

**Patentansprüche**

1. In Gegenwart von Sensibilisatoren unter Lichteinwirkung vernetzbare Stoffgemische, enthaltend

A) ein aliphatisch ungesättigtes Polykondensationsprodukt, das gegebenenfalls Strukturelemente der Formel I

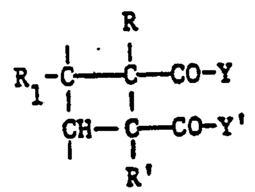

(I)

aufweist, und

B) ein Bisimid der Formel II

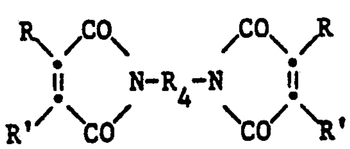

(II) ,

worin R und R' unabhängig voneinander $C_{1-4}$-Alkyl oder zusammen gegebenenfalls durch eine Methylgruppe substituiertes Tetramethylen oder eine Gruppierung der Formel III

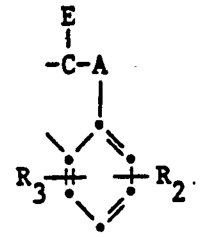

(III) ,

$R_1$ Wasserstoff oder Methyl,
$R_2$ und $R_3$ unabhängig voneinander Wasserstoff, Halogen, $C_{1-4}$-Alkyl oder Methoxy,
A $-CH_2-$, $-CH_2CH_2-$ oder $-OCH_2-$ mit an den aromatischen Ring gebundenem Sauerstoff und E Wasserstoff oder A -O- und E $-CH_3$,
$R_4$ $-C_mH_{2m}-$ mit m = 1 bis 20, $-(CH_2)_xQ(CH_2)_{x'}-$, $-(CH_2)_2NH(CH_2)_2NH(CH_2)_2-$, $-CH_2-Z-CH_2-$, Phenylen, das durch ein oder zwei Chloratome oder eine oder zwei Methylgruppen substituiert sein kann, Naphthylen, eine Gruppe

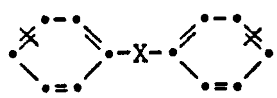

oder

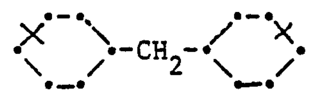

,

Q -S-, -O- oder -NH-,

x und x' unabhängig voneinander eine Zahl von 2 bis 4,
Z Phenylen oder $C_{4-6}$-Cycloalkylen,
X die direkte Bindung, -O-, -S-, $-SO_2-$, $-CH_2-$ oder $-C(CH_3)_2-$ und
Y und Y' je -OH- oder zusammen -O- darstellen, wobei der Anteil an Bisimid der Formel II 0,1 bis 75 Gew.-%, bezogen auf das Polykondensationsprodukt beträgt.

2. Stoffgemische nach Anspruch 1, worin der Anteil an Bisimid der Formel II 1 bis 25 % Gew.-%, bezogen auf das Polykondensationsprodukt A), beträgt.

3. Stoffgemische nach Anspruch 1, worin R und R' zusammen eine Gruppierung der Formel III darstellen, worin E, $R_2$ und $R_3$ Wasserstoff sind und A $-CH_2-$ bedeutet.

4. Stoffgemische nach Anspruch 1, worin R und R' zusammen Tetramethylen, 3- oder 4-Methyltetramethylen und insbesondere je Methyl bedeuten.

5. Stoffgemische nach Anspruch 1, worin $R_4$ geradkettiges $-C_mH_{2m}-$ mit m = 2-10, $-(CH_2)_2Q(CH_2)_2-$ mit Q = -S-, -O- und insbesondere -NH-, $-CH_2-Z-CH_2-$ mit Z = 1,3- oder 1,4-Phenylen, 1,3- oder 1,4-Cyclohexylen; den Rest 4,4'-Diaminodiphenylmethans, 4,4'-Diaminodiphenyläthers oder 4,4'-Diaminophenylsulfids, 1,3- oder 1,4-Phenylen bedeutet.

6. Stoffgemische nach Anspruch 1, worin R und R' je Methyl, $R_1$ Wasserstoff, Y und Y' zusammen -O- und $R_4$ $-(CH_2)_2NH(CH_2)_2-$ und vor allem geradkettiges $-C_mH_{2m}-$ mit m = 2-10 bedeuten.

7. Stoffgemische nach Anspruch 6, worin der Sensibilisator ein unsubstituiertes oder substituiertes Thioxanthon ist.

8. Stoffgemische nach Anspruch 1, worin das Polykondensationsprodukt A) aus wiederkehrenden Strukturelementen der Formel VIa

$-O-CO-CH=CH-CO-O-R_{11}-$ (VIa)

und gegebenenfalls wiederkehrenden Strukturelementen der Formel VIb und/oder Ia

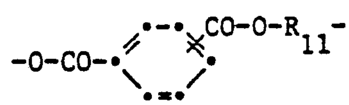

(VIb)

und/oder

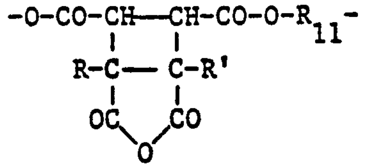

(Ia)

besteht, worin R und R' zusammen Tetramethylen und vor allem je Methyl,

$R_{11}$ eine Gruppe 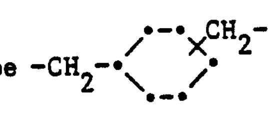 , besonders 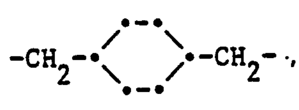 , oder

$(CH_2)_s$ mit s = 2-12 darstellen, und der Anteil an Strukturelementen der Formel Ia bis zu 95 %, bezogen auf die Gesamtzahl der wiederkehrenden Strukturelemente des Polyesters betragen kann.

9. Stoffgemische nach Anspruch 7, worin das Polykondensationsprodukt A) aus Strukturelementen der Formel VIa und gegebenenfalls Strukturelementen der Formel VIb besteht.

10. Stoffgemische nach Anspruch 1, worin das Polykondensationsprodukt A) aus wiederkehrenden Strukturelementen der Formel Va

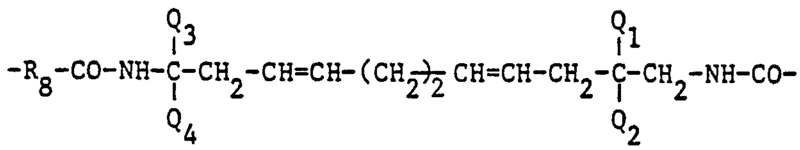
(Va)

und gegebenenfalls wiederkehrenden Strukturelementen der Formeln Ib, Ic und/oder Id

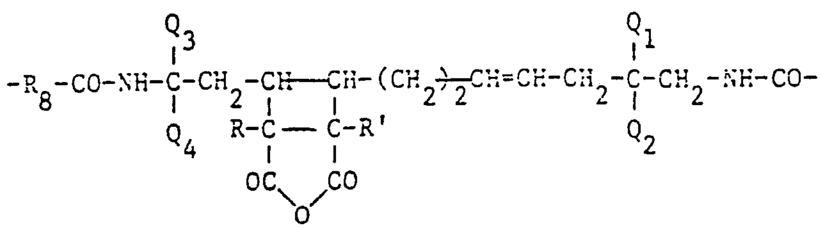
(Ib) ,

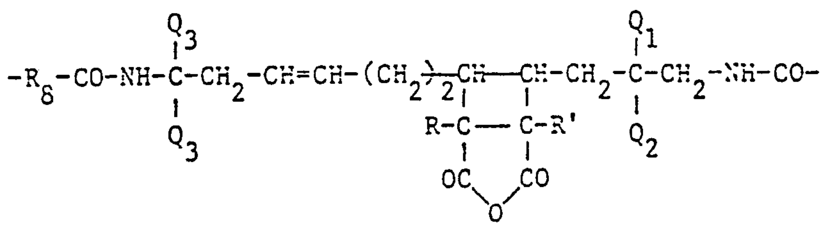
(Ic) ,

und/oder

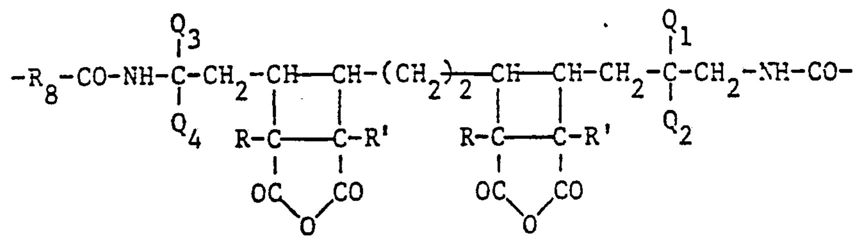
(Id) ,

besteht, worin R und R' zusammen Tetramethylen und vor allem je Methyl,
$Q_1$ $C_{1-12}$-Alkyl,
$Q_2$ Wasserstoff oder $C_{1-12}$-Alkyl,
$Q_3$ $C_{1-12}$-Alkyl, Cycloalkyl mit 4-12 Ring-C-Atomen, Aralkyl mit 7 oder 8 C-Atomen oder Phenyl und
$Q_4$ Wasserstoff, $C_{1-12}$-Alkyl, Cycloalkyl mit 4-12 Ring-C-Atomen, Aralkyl mit 7 oder 8 C-Atomen oder Phenyl oder
$Q_1$ und $Q_2$ und/oder $Q_3$ und $Q_4$ zusammen Alkylen mit 3-11 C-Atomen bedeuten, und
$R_8$ den Rest der Terephthalsäure, Isophthalsäure und/oder einer gesättigten aliphatischen Dicarbonsäure mit 6-12 C-Atomen darstellt wobei der Anteil an Strukturelementen der Formeln Ib, Ic und/oder Id bis zu 95 %, bezogen auf die Gesamtzahl der wiederkehrenden Strukturelemente des Polyamids betragen kann.

11. Stoffgemische nach Anspruch 9, worin $Q_1$ Methyl oder Äthyl, $Q_2$ Wasserstoff, Methyl oder Äthyl, $Q_3$ $C_{1-5}$-Alkyl oder Phenyl, $Q_4$ Wasserstoff oder Methyl und $R_8$ den Rest der Terephthalsäure, Isophthalsäure und/oder einer gesättigten aliphatischen Dicarbonsäure mit 6-10 C-Atomen bedeuten.

12. Stoffgemische nach Anspruch 9, worin das Polykondensationsprodukt A) nur aus wiederkehrenden Strukturelementen der Formel Va besteht, worin $Q_1$ und $Q_2$ Methyl, $Q_3$ Isopropyl, $Q_4$ Wasserstoff und $R_8$ den Rest der Terephthalsäure und/oder Adipinsäure darstellen.

13. Beschichtetes Material, enthaltend ein Substrat, auf das eine lichtempfindliche Schicht aus einem Stoffgemisch gemäss Anspruch 1 aufgebracht ist.

14. Verwendung des Materials nach Anspruch 12 zur Herstellung von Druckplatten oder als Photoresistmaterialien.

15. Verwendung von Polykondensationsprodukten, die wiederkehrende Strukturelemente der Formel I

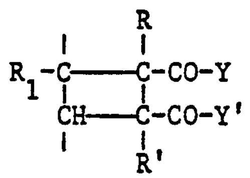

(I)

aufweisen in Stoffgemischen gemäß Anspruch 1, worin R und R' unabhängig voneinander $C_{1-4}$-Alkyl oder zusammen gegebenenfalls durch eine Methylgruppe substituiertes Tetramethylen oder eine Gruppierung der Formel III

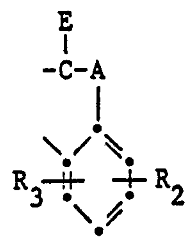

(III),

$R_1$ Wasserstoff oder Methyl,
$R_2$ und $R_3$ unabhängig voneinander Wasserstoff, Halogen, $C_{1-4}$-Alkyl oder Methoxy,
A $-CH_2-$, $-CH_2CH_2-$oder $-OCH_2-$ mit an den aromatischen Ring gebundenem Sauerstoff und E Wasserstoff oder A -O- und E $-CH_3$ bedeuten und y und y' je -OH oder zusammen -O- darstellen.

16. Verwendung nach Anspruch 15, wobei R und R' zusammen Tetramethylen und insbesondere je Methyl und $R_1$ Wasserstoff darstellen.

17. Verwendung von Verbindungen der Formel II in Stoffgemischen gemäß Anspruch 1

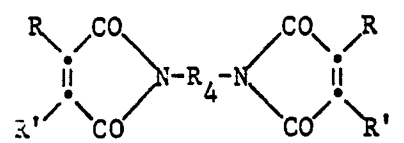

(II),

worin R und R' zusammen gegebenenfalls durch eine Methylgruppe substituiertes Tetramethylen, $R_4$ $-C_mH_{2m}-$ mit m = 1 bis 20, $-(CH_2)_xQ(CH_2)_{x'}-$, $-(CH_2)_2NH(CH_2)_2NH(CH_2)_2-$, $-CH_2-Z-CH_2-$, Phenylen, das durch ein oder zwei Chloratome oder eine oder zwei Methylgruppen substituiert sein kann, Naphthylen, eine Gruppe

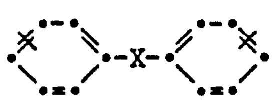 oder 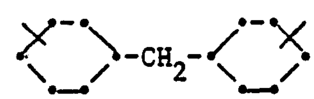,

Q -S-, -O- oder -NH-,
x und x' unabhängig voneinander eine Zahl von 2 bis 4,
Z Phenylen oder $C_{4-6}$-Cycloalkylen, und
X die direkte Bindung, -O-, -S-, $-SO_2-$, $-CH_2-$ oder $-C(CH_3)_2-$ bedeuten.

**Claims**

1. A composition of matter which crosslinks under light in the presence of sensitisers and contains

A) an aliphatically unsaturated polycondensation product which can contain structural elements of the formula I

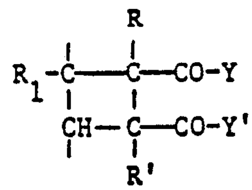

(I)

and

B) a bisimide of the formula II

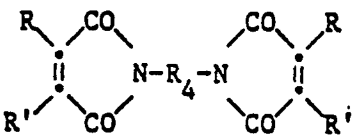

(II)

in which R and R' independently of each other are each $C_{1-4}$-alkyl or together tetramethylene which is ubsubstituted or substituted by a methyl group, or a grouping of the formula III

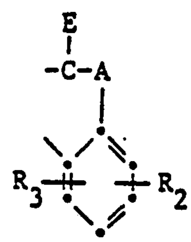

(III)

$R_1$ is hydrogen or methyl,

$R_2$ and $R_3$, independently of each other, are each hydrogen, halogen, $C_{1-4}$-alkyl or methoxy, A is $-CH_2-$, $-CH_2CH_2-$ or $-OCH_2-$ with oxygen bonded to the aromatic ring, and E is hydrogen, or A is -O- and E is $-CH_3$, $R_4$ is $-C_mH_{2m}-$ with m = 1 to 20, $-(CH_2)_xQ(CH_2)_{x'}$, $-(CH_2)_2NH(CH_2)_2NH(CH_2)_2-$, $-CH_2-Z-CH_2-$, phenylene which is unsubstituted or substituted by one or two chlorine atoms or one or two methyl groups, naphthylene or a group of the formula

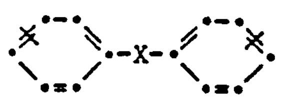 or 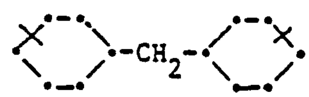

Q is -S-, -O- or -NH-, x and x', independently of each other, are each a number from 2 to 4, Z is phenylene or $C_{4-6}$-cyclo-alkylene, X is a direct bond, -O-, -S-, $-SO_2-$, $-CH_2-$ or $-C(CH_3)_2-$, and Y and Y' are each -OH-or together -O-, and the proportion of bisimide of the formula II is 0.1 to 75 % by weight based on polycondensation product A).

2. A composition of matter according to Claim 1, wherein the proportion of bisimide of the formula II is 1 to 25 % by weight, based on polycondensation product A).

3. A composition of matter according to Claim 1, wherein R and R' together are a grouping of the formula III in which E, $R_2$ and $R_3$ are each hydrogen and A is $-CH_2-$.

4. A composition of matter according to Claim 1, wherein R and R' together are tetramethylene or 3- or 4-methyltetramethylene or in particular are each methyl.

5. A composition of matter according to Claim 1, wherein $R_4$ is straight-chain $-C_mH_{2m}-$ with m = 2-10, $-(CH_2)_2Q(CH_2)_2-$ with Q = -S-, -O- or in particular -NH-, $-CH_2-Z-CH_2-$ with Z = 1,3- or 1,4-phenylene or 1,3- or 1,4-cyclohexylene, the radical of 4,4'-diaminodiphenylmethane, 4,4'-diaminodiphenyl ether or 4,4'-diaminophenyl sulfide or 1,3-or 1,4-phenylene.

6. A composition of matter according to Claim 1, wherein R and R' each are methyl, $R_1$ is hydrogen, Y and Y' together are -O-, and $R_4$ is $-(CH_2)_2NH(CH_2)_2-$ or especially straight-chain $-C_mH_{2m}-$ with m = 2-10.

7. A composition of matter according to Claim 6, wherein the sensitiser is an unsubstituted or substituted thioxanthone.

8. A composition of matter according to Claim 1, wherein polycondensation product A) consists of recurring structural elements of the formula VIa

$-O-CO-CH=CH-CO-O-R_{11}-$ (VIa)

with or without recurring structural elements of the formula VIb and/or Ia

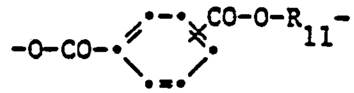 (VIb)

and/or

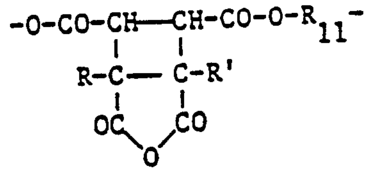 (Ia)

in which R and R′ together are tetramethylene or, especially, are each methyl, $R_{11}$ is a group of the formula

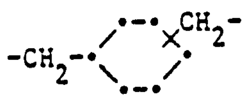 , in particular 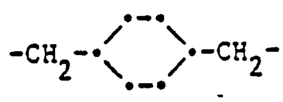 , or $(CH_2)_s$

with s = 2-12, and the proportion of structural elements of the formula Ia can amount to 95 % of the total number of recurring structural elements of the polyester.

9. A composition of matter according to Claim 7, wherein polycondensation product A) consists of structural elements of the formula VIa with or without structural elements of the formula VIb.

10. A composition of matter according to Claim 1, wherein polycondensation product A) consists of recurring structural elements of the formula Va

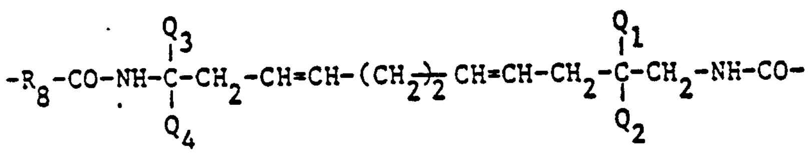 (Va)

with or without recurring structural elements of the formula Ib, Ic and/or Id

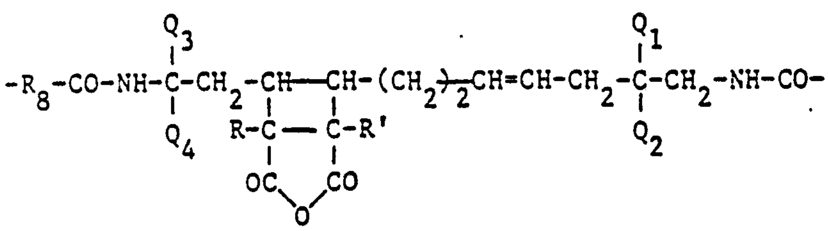 (Ib)

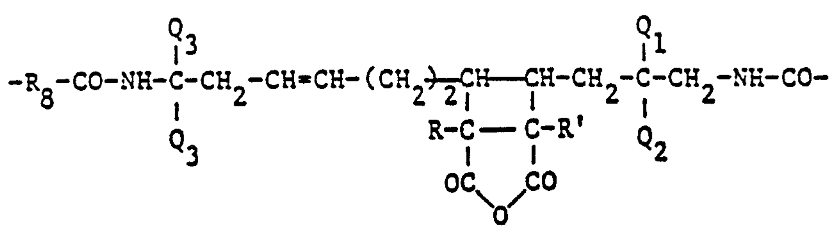 (Ic)

and/or

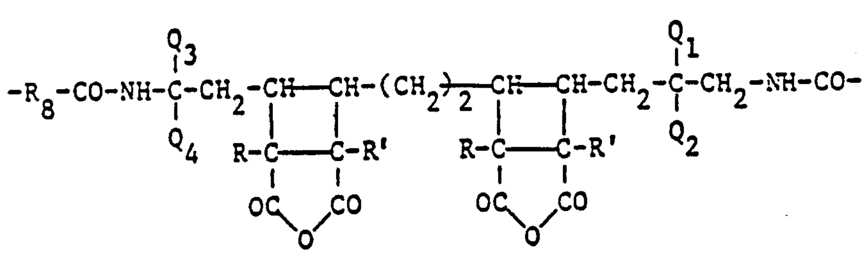 (Id)

in which R and R' together are tetramethylene or, especially, are each methyl, $Q_1$ is $C_{1-12}$-alkyl, $Q_2$ is hydrogen or $C_{1-12}$-alkyl, $Q_3$ is $C_{1-12}$-alkyl, cycloalkyl having 4-12 ring carbon atoms, aralkyl having 7 or 8 carbon atoms, or phenyl, and $Q_4$ is hydrogen, $C_{1-12}$-alkyl, cycloalkyl having 4-12 ring carbon atoms, aralkyl having 7 or 8 carbon atoms, or phenyl, or $Q_1$ and $Q_2$ and/or $Q_3$ and $Q_4$ together are alkylene having 3-11 carbon atoms, and $R_8$ is the radical of terephthalic acid, isophthalic acid and/or of a saturated aliphatic dicarboxylic acid having 6-12 carbon atoms. The proportion of structural elements of the formulae Ib, Ic and/or Id can amount to 95 %, in particular 20-90 %, of the total number of recurring structural elements of the polyamide.

11. A composition of matter according to Claim 9, wherein $Q_1$ is methyl or ethyl, $Q_2$ is hydrogen, methyl or ethyl, $Q_3$ is $C_{1-5}$-alkyl or phenyl, $Q_4$ is hydrogen or methyl and $R_8$ is the radical of terephthalic acid, isophthalic acid and/or a saturated aliphatic dicarboxylic acid having 6-10 carbon atoms.

12. A composition of matter according to Claim 9, wherein polycondensation product A) consists solely consists of recurring structural elements of the formula Va in which $Q_1$ and $Q_2$ each are methyl, $Q_3$ is isopropyl, $Q_4$ is hydrogen, and $R_8$ is the radical of terephthalic acid and/or adipic acid.

13. A coated material containing a substrate to which a light-sensitive layer of a composition of matter according to Claim 1 has been applied.

14. Use of the material according to Claim 12 for preparing printing plates or as photoresist materials.

15. The use in a composition of matter according to Claim 1 of a polycondensation product which has recurring structural elements of the formula I

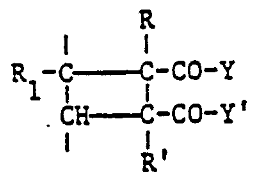 (I)

in which R and R' independently of each other, each are $C_{1-4}$-alkyl or together are tetramethylene which is unsubstituted or substituted by a methyl group or a grouping of the formula III

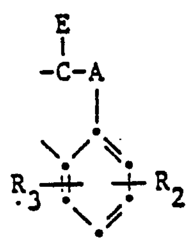 (III)

in which $R_1$ is hydrogen or methyl, $R_2$ and $R_3$, independently of each other, each are hydrogen, halogen, $C_{1-4}$-alkyl or methoxy, and A is $-CH_2-$, $-CH_2CH_2-$ or $-OCH_2-$ with oxygen bonded to the aromatic ring and E is hydrogen, or A is -O- and E is $-CH_3$ and y and y' each are -OH or together are -O-.

16. The use according to Claim 15, wherein R and R' together are tetramethylene or in particular are each methyl, and $R_1$ is hydrogen.

17. The use in a composition of matter according to Claim 1 of a compound of the formula II

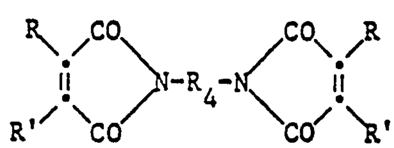 (II)

in which R and R' together are tetramethylene which is unsubstituted or substituted by a methyl group, $R_4$ is $-C_mH_{2m}-$ with m = 1 to 20, $-(CH_2)_xQ(CH_2)_{x'}-$, $-(CH_2)_2NH(CH_2)_2NH(CH_2)_2-$, $-CH_2-Z-CH_2-$, phenylene is unsubstituted or substituted by one or two chlorine atoms or one or two methyl groups, naphthylene, or a group of the formula

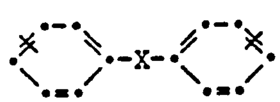 or 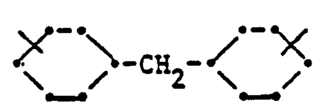

Q is -S-, -O- or -NH-, x and x' independently of each other, are each a number from 2 to 4, Z is phenylene or $C_{4-6}$-cyclo-alkylene, and X is a direct bond, -O-, -S-, $-SO_2-$, $-CH_2-$or $-C(CH_3)_2-$.

**Revendications**

1. Mélanges susceptibles d'être réticulés sous l'action de la lumière en présence de sensibilisateurs, mélanges qui contiennent:

A) un produit de polycondensation à insaturation aliphatique, qui contient éventuellement des éléments structuraux (motifs) de formule I:

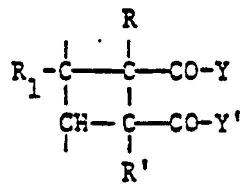

(I)

et

B) un bis-imide de formule II:

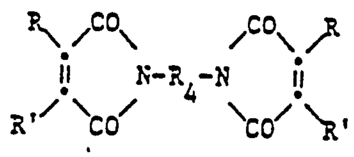

(II) ,

formules dans lesquelles:

R et R' représentent chacun, indépendamment l'un de l'autre, un alkyle en $C_1$-$C_4$ ou forment ensemble un radical tétraméthylène éventuellement porteur d'un radical méthyle, ou un radical de formule III

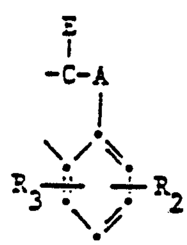

(III) ,

$R_1$ représente l'hydrogène ou un méthyle,

$R_2$ et $R_3$ représentent chacun, indépendamment l'un de l'autre, l'hydrogène, un halogène, un alkyle en $C_1$-$C_4$ ou un méthoxy,

A représente un radical $-CH_2-$ ou $-CH_2CH_2-$ ou représente un radical $-OCH_2-$ dont l'oxygène est lié au noyau aromatique, et E représente l'hydrogène,

ou

A représente -O- et E représente $-CH_3$,

$R_4$ représente un radical $-C_mH_{2m}-$ dont l'indice m désigne un nombre de 1 à 20, un radical $-(CH_2)_xQ(CH_2)_{x'}-$, $-(CH_2)_2NH(CH_2)_2NH(CH_2)_2-$ ou $-CH_2-Z-CH_2-$, un radical phénylène éventuellement porteur d'un ou de deux atomes de chlore ou d'un ou de deux radicaux méthyles, un radical naphtylène, ou un radical:

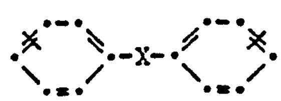 ou 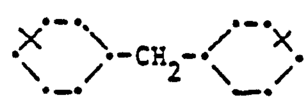 ,

Q représente -S-, -O- ou -NH-,

x et x' représentent chacun, indépendamment l'un de l'autre, un nombre de 2 à 4,

Z représente un radical phénylène ou un radical cycloalkylène en $C_4$-$C_6$,

X représente une liaison directe, -O-, -S-, $-SO_2-$, $-CH_2-$ou $-C(CH_3)_2-$,

et

Y et Y' représentent chacun un radical -OH ou, ensemble, -O-,

la quantité du bis-imide de formule II représentant de 0,1 à 75 % en poids par rapport au produit de polycondensation A).

2. Mélanges selon la revendication 1 dans lesquels la quantité du bis-imide de formule II représente de 1 à 25 % en poids par rapport au produit de polycondensation A).

3. Mélanges selon la revendication 1 caractérisés en ce que R et R' forment ensemble un groupement de formule III dans lequel E, $R_2$ et $R_3$ représentent chacun l'hydrogène et A représente un radical $-CH_2-$.

4. Mélanges selon la revendication 1 dans lesquels R et R' forment ensemble un radical tétraméthylène, méthyl-3 tétraméthylène ou méthyl-4 tétraméthylène, ou, mieux, représentent chacun un radical méthyle.

5. Mélanges selon la revendication 1 dans lesquels $R_4$ représente un radical $-C_mH_{2m}-$ linéaire dont l'indice m est un nombre de 2 à 10, un radical $-(CH_2)_2Q(CH_2)_2-$ dans lequel Q représente -S-, -O- ou, plus spécialement, -NH-, un radical $-CH_2-Z-CH_2-$ dans lequel Z représente un radical phénylène-1,3, phénylène-1,4, cyclohexylène-1,3 ou cyclohexylène-1,4, ou $R_4$ représente le radical du diamino-4,4' diphénylméthane, de l'oxyde de bis-(amino-4 phényle) ou du sulfure de bis-(amino-4 phényle), un radical phénylène-1,3 ou un radical phénylène-1,4.

6. Mélanges selon la revendication 1 dans lesquels R et R' représentent chacun un méthyle, $R_1$ représente l'hydrogène, Y et Y' représentent ensemble -O-, et $R_4$ représente un radical $-(CH_2)_2NH(CH_2)_2-$ ou, mieux, un radical $-C_mH_{2m}-$ linéaire dont l'indice m est un nombre de 2 à 10.

7. Mélanges selon la revendication 6 dans lesquels le sensibilisateur est une thioxanthone substituée ou non.

8. Mélanges selon la revendication 1 dans lesquels le produit de polycondensation A) est constitué d'éléments structuraux répétés de formule VIa:

$-O-CO-CH=CH-CO-O-R_{11}-$ (VIa)

et, éventuellement, d'éléments structuraux répétés de formules VIb et/ou Ia:

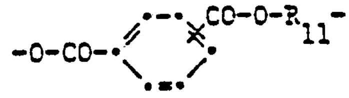

(VIb)

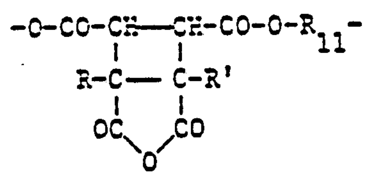

(Ia),

formules dans lesquelles R et R' forment ensemble un radical tétraméthylène ou, mieux, représentent chacun un méthyle,

$R_{11}$ représente un radical 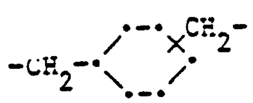 , plus

particulièrement un radical 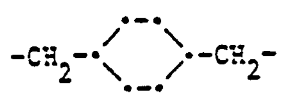 ,

ou un radical $-(CH_2)_s-$ dont l'indice s désigne un nombre de 2 à 12, et la proportion des éléments structuraux de formule Ia peut aller jusqu'à 95 % par rapport au nombre total des éléments structuraux répétés du polyester.

9. Mélanges selon la revendication 8 dans lesquels le produit de polycondensation A) est constitué d'éléments structuraux de formule VIa et, éventuellement, d'éléments structuraux de formule VIb.

10. Mélanges selon la revendication 1 dans lesquels le produit de polycondensation A) est constitué d'éléments structuraux répétés de formule Va:

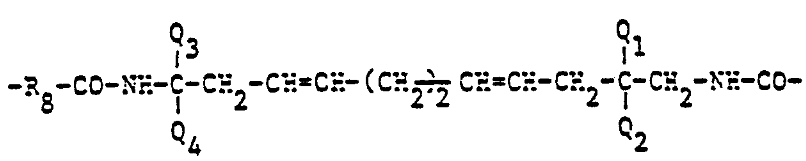

(Va)

et, éventuellement, d'éléments structuraux répétés de formules Ib, Ic et/ou Id:

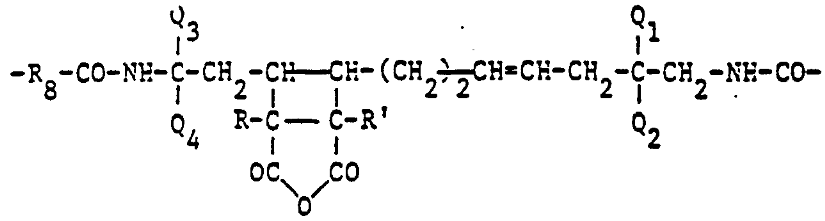 (Ib) ,

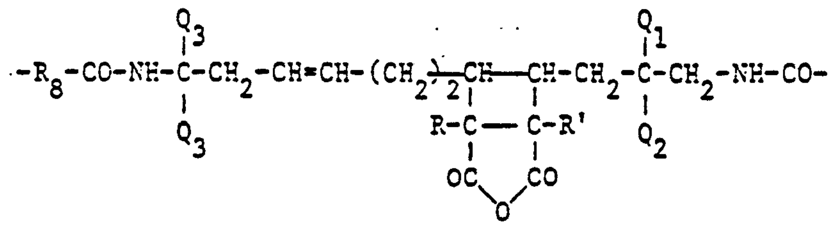 (Ic) ,

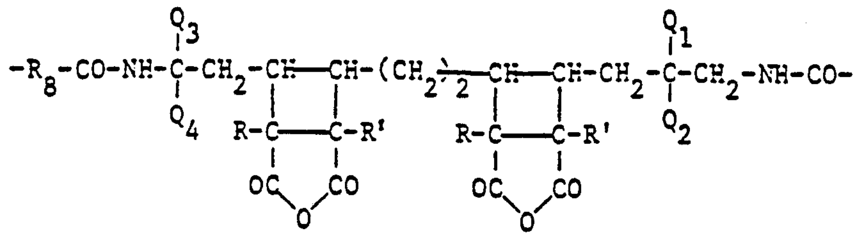 (Id) ,

formules dans lesquelles:

R et R' forment ensemble un radical tétraméthylène ou, mieux, représentent chacun un radical méthyle,

$Q_1$ représente un alkyle en $C_1$-$C_{12}$,

$Q_2$ représente l'hydrogène ou un alkyle en $C_1$-$C_{12}$,

$Q_3$ représente un alkyle en $C_1$-$C_{12}$, un cycloalkyle contenant de 4 à 12 atomes de carbone dans son cycle, un aralkyle à 7 ou 8 atomes de carbone ou un phényle, et

$Q_4$ représente l'hydrogène, un alkyle en $C_1$-$C_{12}$, un cycloalkyle contenant de 4 à 12 atomes de carbone dans son cycle, un aralkyle à 7 ou 8 atomes de carbone ou un phényle,

ou

$Q_1$ et $Q_2$, et/ou $Q_3$ et $Q_4$, forment ensemble un alkylène en $C_3$-$C_{11}$,

et

$R_8$ représente le radical de l'acide téréphtalique, de l'acide isophtalique et/ou d'un acide dicarboxylique aliphatique saturé contenant de 6 à 12 atomes de carbone,

la proportion des éléments structuraux de formules Ib, Ic et/ou Id pouvant aller jusqu'à 95 % par rapport au nombre total des éléments structuraux répétés du polyamide.

11. Mélanges selon la revendication 10 dans lesquels $Q_1$ représente un méthyle ou un éthyle, $Q_2$ l'hydrogène, un méthyle ou un éthyle, $Q_3$ un alkyle en $C_1$-$C_5$ ou un phényle, $Q_4$ l'hydrogène ou un méthyle, et $R_8$ le radical de l'acide téréphtalique, de l'acide isophtalique et/ou d'un acide dicarboxylique aliphatique saturé contenant de 6 à 10 atomes de carbone.

12. Mélanges selon la revendication 10 dans lesquels le produit de polycondensation A) n'est constitué que d'éléments structuraux répétés de formule Va dans lesquels $Q_1$ et $Q_2$ représentent chacun un méthyle, $Q_3$ représente un isopropyle, $Q_4$ l'hydrogène et $R_8$ le radical de l'acide téréphtalique et/ou de l'acide adipique.

13. Matière revêtue qui comporte un substrat sur lequel est appliquée une couche photosensible à base d'un mélange selon la revendication 1.

14. Application de la matière selon la revendication 13 à la fabrication de clichés d'imprimerie ou comme matières pour photomasques.

15. Application, dans des mélanges selon la revendication 1, de produits de polycondensation qui contiennent des éléments structuraux répétés répondant à la formule I:

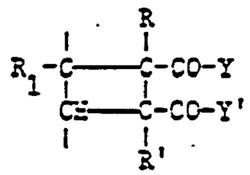

(I)

dans laquelle:

R et R' représentent chacun, indépendamment l'un de l'autre, un alkyle en $C_1$-$C_4$ ou forment ensemble un radical tétraméthylène éventuellement porteur d'un méthyle, ou un groupement de formule III:

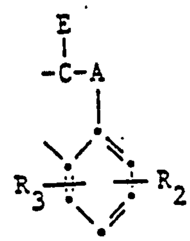

(III) ,

$R_1$ représente l'hydrogène ou un méthyle,

$R_2$ et $R_3$ représentent chacun, indépendamment l'un de l'autre, l'hydrogène, un halogène, un alkyle en $C_1$-$C_4$ ou un méthoxy,

A représente $-CH_2-$, $-CH_2CH_2-$ ou un radical $-OCH_2-$ dont l'oxygène est lié au cycle aromatique, et E représente l'hydrogène, ou A représente -O- et E un radical $-CH_3$, et

Y et Y' représentent chacun -OH ou, ensemble, -O-.

16. Application selon la revendication 15, caractérisée en ce que R et R' représentent ensemble un radical tétraméthylène ou, plus particulièrement, représentent chacun un radical méthyle et $R_1$ représente l'hydrogène.

17. Application, dans des mélanges selon la revendication 1, de composés répondant à la formule II:

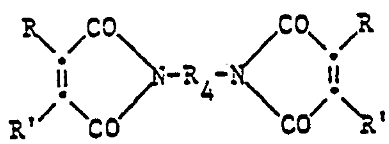

(II)

dans laquelle:

R et R' représentent ensemble un radical tétraméthylène éventuellement porteur d'un méthyle,

$R_4$ représente un radical $-C_mH_{2m}-$ dans lequel m désigne un nombre de 1 à 20, un radical $(CH_2)_xQ(CH_2)_{x'}-$, $-(CH_2)_2NH(CH_2)_2NH(CH_2)_2-$ ou $-CH_2-Z-CH_2-$, un radical phénylène éventuellement porteur d'un ou de deux atomes de chlore ou d'un ou de deux radicaux méthyles, un naphtylène, un radical:

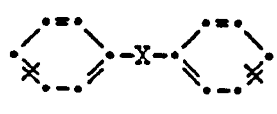

ou un radical

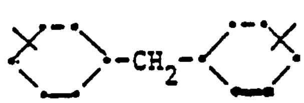

,

Q représente -S-, -O- ou -NH-,

x et x' représentent chacun, indépendamment l'un de l'autre, un nombre de 2 à 4,

Z représente un phénylène ou un cycloalkylène en $C_4$-$C_6$, et X représente une liaison directe, -O-, -S-, $-SO_2-$, $-CH_2-$ ou $-C(CH_3)_2-$.